Europäisches Patentamt

European Patent Office

Office européen des brevets

(19)

(11) Numéro de publication: **0 214 033 B1**

(12) **FASCICULE DE BREVET EUROPEEN**

(45) Date de publication de fascicule du brevet:
**25.09.91**

(51) Int. Cl.⁵: **H01L 27/146**, H01L 27/14

(21) Numéro de dépôt: **86401789.2**

(22) Date de dépôt: **08.08.86**

(54) **Procédé de fabrication d'un détecteur d'image lumineuse, et détecteur linéaire d'images obtenu par ce procédé.**

(30) Priorité: **14.08.85 FR 8512420**

(43) Date de publication de la demande:
**11.03.87 Bulletin 87/11**

(45) Mention de la délivrance du brevet:
**25.09.91 Bulletin 91/39**

(84) Etats contractants désignés:
**DE GB NL**

(56) Documents cités:
**DE-A- 2 344 099**
**GB-A- 2 132 016**
**US-A- 4 316 206**
**US-A- 4 482 804**

**PATENTS ABSTRACTS OF JAPAN, vol. 9, no. 150 (E-324)[1873], 25 juin 1986; & JP-A-60 32 360**

**EXTENDED ABSTRACTS OF THE 15TH CONFERENCE ON SOLID STATE DEVICES AND MATERIALS, pages 205-208, Tokyo, JP; H .YAMAMOTO et al.:"High speed contact type linear sensor array using a-Si pin diodes"**

(73) Titulaire: **THOMSON-CSF**
**51, Esplanade du Général de Gaulle**
**F-92800 Puteaux(FR)**

(72) Inventeur: **Szydlo, Nicolas**
**THOMSON-CSF SCPI 19, avenue de Messine**
**F-75008 Paris(FR)**
Inventeur: **Boulitrop, François**
**THOMSON-CSF SCPI 19, avenue de Messine**
**F-75008 Paris(FR)**

(74) Mandataire: **Lepercque, Jean et al**
**THOMSON-CSF SCPI**
**F-92045 PARIS LA DEFENSE CEDEX 67(FR)**

EP 0 214 033 B1

Rank Xerox (UK) Business Services

## Description

L'invention concerne un procédé de fabrication d'un détecteur d'image lumineuse et un détecteur linéaire obtenu par ce procédé. Elle se place dans le contexte de réalisation de circuits électroniques en couche mince sur de grandes surfaces.

Elle s'applique notamment dans les dispositifs de réalisation de fac-similé par contact sans optique de réduction.

Depuis la découverte de la grande photoconductivité du silicium amorphe et sa capacité de dépôt sur grande surface, de nombreuses applications sont à l'étude en particulier les détecteurs grande échelle pour des machines de fac-similé de bureau compactes. Les recherches se sont orientées vers l'intégration de l'élément photoconducteur associé à un dispositif électronique bloquant (bloquer les interférences entre les photoconducteurs et commutateurs de lecture).

L'application visée dans la présente invention est la commande intégrée de chaque point élémentaire d'un détecteur d'images lumineuses.

A l'heure actuelle, les principales applications associant la grande photoconductivité du silicium amorphe à la possibilité de réaliser l'électronique de commande dans ce même matériau et sur le même support concerne les détecteurs d'images linéaires, de grande dimension (jusqu'à 20 cm), nécessaires à la lecture de documents de format A4 par déplacement latéral du document par rapport au senseur.

Trois structures différentes ont été envisagées pour réaliser de tels détecteurs linéaires :

- l'association d'un photoconducteur, d'une capacité de stockage, et d'un transistor en couche mince (T.F.T.) en silicium amorphe (a-Si) tel que cela est décrit dans l'article de M.MATSUMURA, paru dans la revue IEEE Electron Device Letters, EDL-1, p. 182 (1980);
- l'association d'une photodiode en silicium amorphe ou polycristallin telle que décrite dans "Extended Abstracts of the 15th Conference on Solid State Devices and Materials", TOKYO (1983), p. 201 à 204 par F.OKUMURA;
- l'association d'une photodiode et d'une diode bloquante en a-Si telle que décrite par Y. YAMAMOTO dans "Extended Abstracts of the 15th Conference on Solid State Devices and Materials", Tokyo (1983), p. 205 à 208. Une telle association est également décrite dans US-A-4 482 804 divulguant la combinaison d'une photodiode et d'une diode bloquante en a: Si placées côte à côte, la photodiode étant constituée de plusieurs diodes pin superposées et montées en série.

Certaines de ces structures permettent d'obtenir des dispositifs présentant les caractéristiques suivantes:
Longueur : 50 mm
Résolution : 8 à 10 bits/mm
Taille du pixel : 100$\mu$m × 70 $\mu$m
Temps de lecture : 2$\mu$s/bit sans multiplexage.

Ces résultats laissent supposer la réalisation prochaine de détecteurs linéaires permettant la reproduction de documents dans de bonnes conditions: par exemple, pour des documents de 216 mm de largeur, à raison de 8 bits par millimètre et à une vitesse de défilement du papier de 5 ms par ligne.

Une barette format A4 (216 mm) doit alors représenter 1728 couples photoconducteurs + commutateurs pour avoir 8 bits/mm ou 3456 couples pour avoir 16 bits/mm dans la tendance future.

On conçoit qu'un nombre si élevé de dispositifs électroniques sur une telle distance exige une structure et une technologie les plus simples possibles. C'est la première contrainte, et en ce sens, la structure complexe des transistors en couches minces (TFT) n'est pas très bien appropriée.

La deuxième contrainte est issue du mode de lecture rapide du document, à savoir environ 2$\mu$s/bit. Ici encore les diodes aux temps de photoréponse et de commutation rapides apparaissent mieux appropriées que les transistors en couches minces.

La troisième contrainte est l'intégration sur le même substrat du circuit matriciel de connexion afin de réduire le nombre de circuits de commande hybrides et ceci avec un nombre de niveaux de masquage le moins élevé possible.

Une dernière contrainte est d'élaborer des dispositifs électroniques performants dans le sens d'un courant d'obscurité très faible.

L'objet de l'invention concerne un détecteur d'images linéaire associant en chaque point une photodiode et une diode bloquante en silicium amorphe et superposées avec intégration du circuit matriciel.

Selon l'invention, les diodes Schottky ou pin sont bien adaptées surtout si les couches de silicium amorphe composant les diodes sont déposées successivement et naturellement sur le même substrat.

Les contraintes énumérées ci-dessus sont respectées avec l'avantage que le procédé de l'invention permet d'obtenir un tel détecteur avec un niveau de masquage réduit.

L'invention concerne un procédé de fabrication d'un détecteur d'image lumineuse tel que défini par les termes des revendications 1 à 3.

L'invention concerne également un détecteur linéaire d'image lumineuse selon la revendication 7.

Des modes particuliers de réalisation de l'invention sont indiqués dans les revendications dépendantes.

Les différents objets et caractéristiques de l'invention vont maintenant être décrits en se reportant aux figures annexées qui représentent:
- les figures 1 à 6, le procédé de réalisation de détecteurs selon l'invention;
- la figure 7, une vue simplifiée en perspective de détecteurs selon l'invention;
- la figure 8, une vue de dessus d'une disposition matricielle de détecteurs selon l'invention;
- la figure 9, une vue de dessus d'une variante d'une disposition matricielle selon l'invention.

Selon l'invention, le procédé de fabrication de détecteurs d'images lumineuses prévoit, au cours d'une première phase, le dépôt sur un substrat 1, tel que du verre, d'une couche d'un matériau conducteur 2 qui pourra être selon le mode d'utilisation un conducteur en matériau transparent comme on le verra ultérieurement. On dépose ainsi une fine couche d'oxyde mixte d'étain et d'indium (ITO) ou un matériau équivalent ($In_2O_3$, $SnO_2$). Une telle couche aura une épaisseur de 50 à 150 nm (500 à 1500 Angstroem) (125 nm (1250 Angstroem) par exemple).

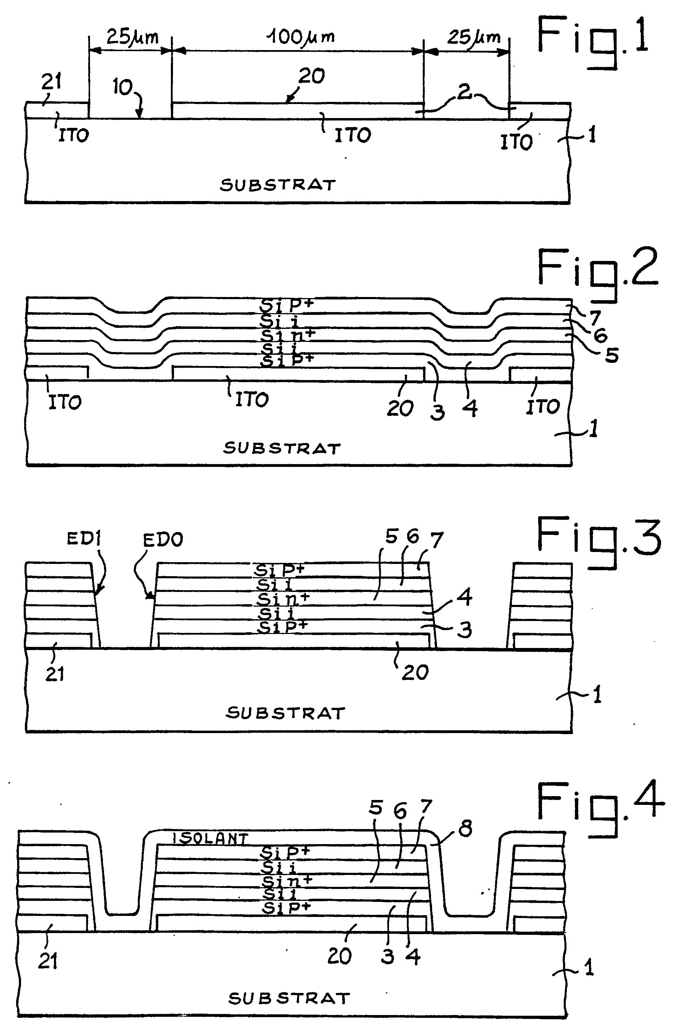

Au cours d'une deuxième phase on grave la couche de matériau conducteur 2 de façon à obtenir un réseau de conducteurs (20, 21) parallèles. On obtient ainsi une structure, telle que représentée en figure 1, dans laquelle chaque conducteur (20, 21) a une largeur de 100 μm et sont séparés de 25 μm de façon à avoir 8 bits par millimètre. L'ITO est ensuite recuit pour le rendre conducteur.

Au cours d'une troisième phase, on dépose une couche 3 de silicium amorphe dopée P de 30 nm (300 Angstroem) environ d'épaisseur. Ce dépôt se fait par une méthode connue de dépôt de silicium amorphe telle que décharge luminescente, pulvérisation réactive.

Au cours d'une quatrième phase, on dépose une couche 4 de silicium amorphe non dopé par une méthode identique à celle de la phase précédente. Cette couche a une épaisseur d'environ 500 nm (5000 Angstroem).

Au cours d'une cinquième phase, on dépose une couche 5 de silicium amorphe dopé N de la même façon que précédemment. Cette couche a une épaisseur de 30 nm (300 Angstroem) environ.

Au cours d'une sixième phase, on dépose une couche 6 de silicium amorphe non dopé par une méthode identique à celle de la phase précédente. Cette couche a une épaisseur d'environ 300 nm (3000 Angstroem).

Au cours d'une septième phase, on dépose une couche 7 de silicium amorphe dopé P de la même façon que précédemment. Cette couche a une épaisseur d'environ 30 nm (300 Angstroem).

On obtient ainsi une structure représentée en figure 2. L'épaisseur des cinq couches de silicium 3 à 7 est alors d'environ 900 nm (9000 Angstroem).

Au cours d'une huitième phase, on découpe dans ces cinq couches des détecteurs individuels tels que les détecteurs EDO et ED1 de la figure 3. Cette phase de découpe peut se faire par photolithographie. Cette photolithographie implique un masquage nécessitant que chaque détecteur individuel soit situé sur un conducteur (20, 21). Le masquage est suivi d'une gravure sèche ou chimique des cinq couches de semi-conducteur 3 à 7.

Sur la figure 3, on obtient ainsi une photodiode de type PIN et une diode bloquante en silicium amorphe superposées.

Cependant, la couche de silicium amorphe 3 aurait pu être dopée de type N, la couche de silicium amorphe 5 doit alors être dopée de type P et la couche de silicium amorphe 7 doit être dopée de type N. On obtient alors une structure dont les diodes sont inversées par rapport à la structure représentée en figure 3.

Au cours d'une neuvième phase, on dépose une couche d'isolant 8. L'isolant utilisé peut être de la silice ou un nitrure de silicium. La technique de dépôt employée peut être une décharge luminescente ou une pulvérisation réactive à une température compatible avec la nature des couches de silicium déjà déposées. On obtient ainsi une structure du type représenté par la figure 4.

On procède ensuite à l'élimination du matériau isolant 8 situé à la surface de la couche 7 de semi-conducteur dopé de type P des détecteurs EDO, ED1. Cet enlèvement d'isolant peut se faire par attaque chimique ou plasma.

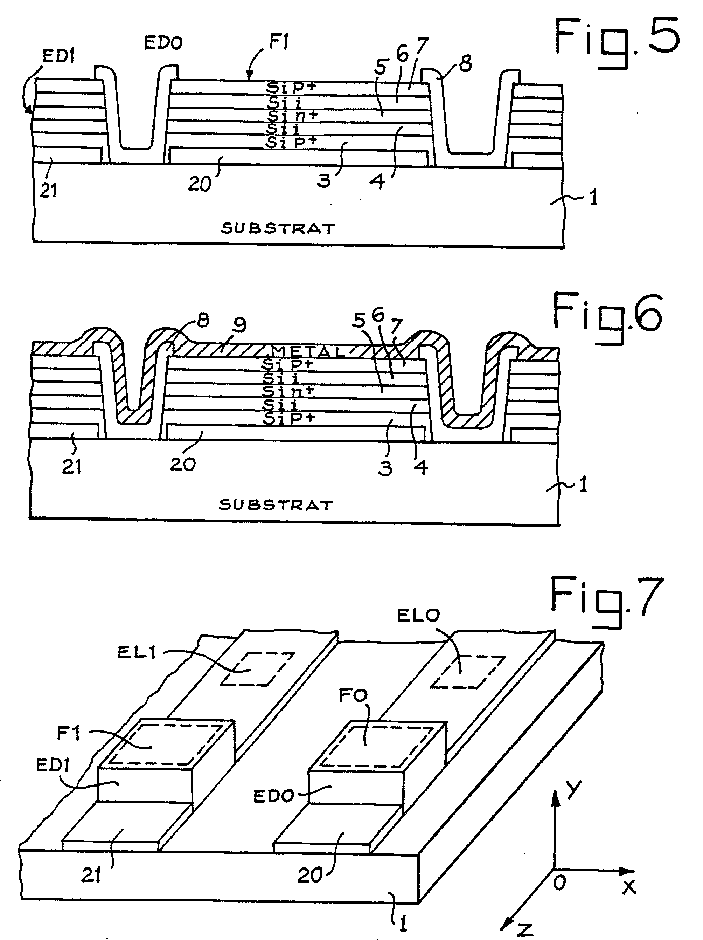

Dans le cas où le matériau conducteur n'est pas transparent on peut alors prévoir de recouvrir l'isolant 8 d'une couche d'une résine négative. On insole alors l'ensemble à travers le substrat 1 à l'aide d'une source d'éclairement située sous le substrat 1 et non représentée sur les figures. La couche 2 sert de masque pour l'isolant situé au-dessus des détecteurs EDO, ED1 et après développement, l'isolant se trouvant au-dessus des détecteurs est éliminé. On obtient une structure telle que représentée en figure 5.

On prévoit également un enlèvement d'isolant en des emplacements situés sur les conducteurs 20, 21.

On obtient ainsi une structure telle que représentée de manière simplifiée en figure 7.

Sur cette figure, on trouve un substrat 1 placé parallèlement au plan OXZ d'un trièdre OXYZ. Les conducteurs 20 et 21 sont orientés selon une direction parallèle à l'axe OZ. Les détecteurs EDO et ED1 sont placés respectivement sur les conducteurs 20 et 21. L'ensemble est recouvert d'une couche d'isolant non représentée. A la face supérieure des détecteurs EDO et ED1 ainsi que sur les conducteurs 20 et 21 sont représentées en traits pointillés, les fenêtres FO, F1, ELO et EL1 pratiqués dans la couche d'isolant.

Au cours d'une dixième phase, on dépose une couche métallique 9 tel que du chrome, de l'aluminium, du palladium ou du molybdène par évaporation ou pulvérisation cathodique sous vide. L'épaisseur de la couche 9 doit être de quelques centaines d'angstroem, 60 nm (600 Angstroem) par exemple. Comme représenté en figure 6, l'ensemble de la structure précédente se trouve recouverte d'une couche métallique 9.

Au cours d'une onzième phase, on procède à la gravure de la couche métallique 9 de façon à établir des connexions électriques des fenêtres FO, F1, ELO, EL1 vers les circuits extérieurs. Cette gravure peut se faire par découpe photolithographique.

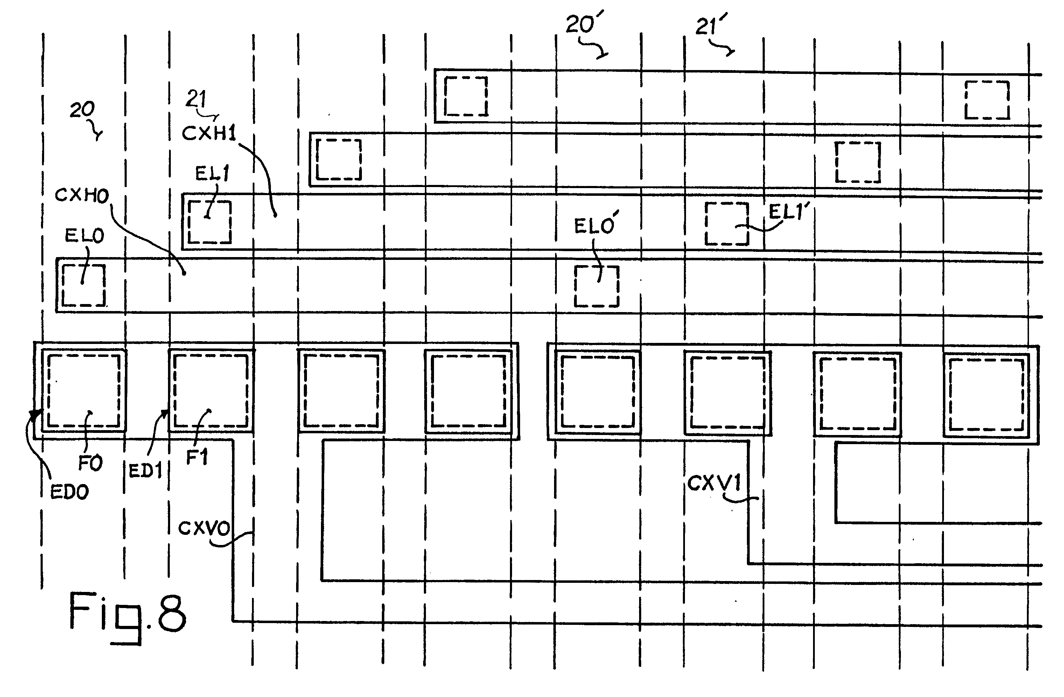

Comme représenté en figure 8, les détecteurs individuels (EDO, ED1) sont disposés linéairement et arrangés en ensemble de quatre détecteurs individuels par exemple. Dans chaque ensemble les détecteurs individuels sont rangés selon un ordre déterminé.

La connexion des fenêtres FO, F1 des détecteurs individuels EDO, ED1 se fait, comme représenté en figure 8, en regroupant par une même connexion verticale CXV0, CXV1, un ensemble de détecteurs individuels. Chaque connexion verticale CXVO, CXV1 permet donc de connecter les faces supérieures (couche 7) d'un ensemble de détecteurs individuels vers des circuits d'accès extérieurs non représentés.

La connexion des fenêtres ELO, EL1 des conducteurs 20, 21, 20', 21' est telle qu'elle regroupe les conducteurs permettant d'accéder aux détecteurs individuels de même rang dans chaque ensemble de détecteurs individuels. C'est ainsi qu'une connexion horizontale CXHO interconnecte les fenêtres ELO et ELO' des conducteurs 20 et 20' et une connexion horizontale CXH1 interconnecte les fenêtres EL1 et EL1' des conducteurs 21 et 21'.

Chaque connexion horizontale CXHO, CXH1, connecte par les conducteurs (tels 20, 21, 20', 21'), les couches inférieures (couche 3) des détecteurs individuels de même rang vers des circuits d'accès extérieurs non représentés.

Pour commander un détecteur individuel déterminé, on sélectionne une connexion verticale et une connexion horizontale. Par exemple, la connexion verticale CXVO et la connexion horizontale CXHO permet d'accéder au détecteur individuel EDO. On a ainsi réalisé une commande matricielle d'un détecteur dont les détecteurs individuels sont disposés linéairement.

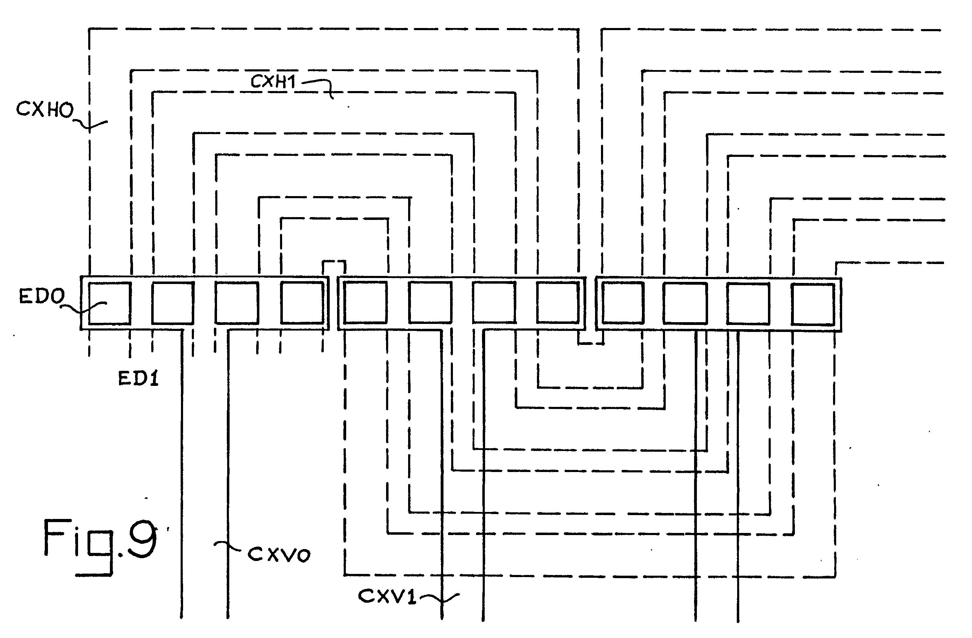

Selon un autre exemple de réalisation de l'invention représenté en figure 9, les conducteurs 20, 21, réalisés sur le substrat 1 au cours des deux premières phases du procédé de l'invention, ont une forme sinueuse de telle façon qu'un conducteur relie les détecteurs individuels de même rang dans chaque ensemble. Une connexion horizontale (CXHO, CXH1) correspond alors à un tel conducteur (20, 21 respectivement). L'enlèvement d'isolant en des emplacements situés sur les conducteurs 20, 21 et prévu dans la neuvième phase du procédé décrite précédemment, n'est donc plus utile. De même, la réalisation des connexions horizontales prévue au cours de la onzième phase n'est plus à prévoir puisque ces connexions horizontales CXHO et CXH1 ont été faites sous la forme des conducteurs 20, 21.

Selon une variante du procédé de fabrication de l'invention, la gravure de la couche de matériau conducteur 2 n'est pas effectuée au cours de la deuxième phase précédente. Par contre, la huitième phase de découpe prévoit une découpe de colonnes parallèles dans les cinq couches de matériau semi-conducteurs 3 à 7 ainsi que dans la couche de matériau conducteur. Cette découpe est ensuite suivie d'une découpe des détecteurs individuels (EDO, ED1) dans les cinq couches de matériau semi-conducteur 3 à 7 de ces colonnes.

Cette façon de procéder permet d'éviter un problème de positionnement des détecteurs individuels (EDO, ED1) sur les conducteurs (20, 21).

Selon une autre variante de l'invention, la cinquième couche de matériau semi-conducteur 7 dopée P, n'est pas déposée. Une couche métallique ou plus simple la couche de matériau métallique 9 des connexions verticales (CXVO, CXV1) la remplace. Dans ces conditions, au lieu d'avoir, à la partie supérieure de chaque détecteur individuel, une diode de type NIP, on obtient une diode Schottky.

Il est à noter que les exemples de réalisations des figures 8 et 9 prévoyant des ensembles de quatre détecteurs et permettant une commande matricielle 4×4 n'a été donnée qu'à titre d'exemple. Pour réduire le nombre de connexions et de circuits d'accès, il sera possible de prévoir des ensembles plus importants et de réaliser par exemple des commandes matricielles de 42 sur 42.

**Revendications**

1. Procédé de fabrication d'un détecteur linéaire d'image lumineuse comprenant plusieurs détecteurs individuels, chaque détecteur individuel étant constitué par une photodiode et une diode bloquante connectées en série, le procédé comportant les phases successives suivantes :

a) une première phase de dépôt sur une face (10) d'un substrat (1) d'une première couche d'un matériau conducteur (2) ;

b) une deuxième phase de dépôt d'une première couche (3) de semi-conducteur amorphe dopé d'un premier type de conductivité (p ou n) ;

c) une troisième phase de dépôt d'une deuxième couche (4) de semi-conducteur amorphe non dopé ;

d) une quatrième phase de dépôt d'une troisième couche (5) de semi-conducteur amorphe dopé d'un deuxième type de conductivité (n ou p) opposé au premier type de conductivité ;

e) une cinquième phase de dépôt d'une quatrième couche (6) de semi-conducteur amorphe non dopé ;

f) une sixième phase de dépôt d'une cinquième couche (7) de semi-conducteur amorphe dopé du premier type de conductivité (p ou n) ;

g) une septième phase de gravure de colonnes dans les cinq couches (3 à 7) de semi-conducteur déposées précédemment, ainsi que dans la première couche de matériau conducteur (2) ;

h) une huitième phase de gravure dans les cinq couches de semi-conducteur des colonnes précédentes, des détecteurs individuels (ED0, ED1) ;

i) une neuvième phase d'isolation des flancs des détecteurs individuels (ED0, ED1), ainsi que des colonnes de la première couche de matériau conducteur (2) ;

j) une dixième phase de dépôt d'une deuxième couche d'un matériau conducteur (9) fournissant un contact ohmique ;

k) et une onzième phase de gravure dans la deuxième couche de matériau conducteur (9) des connexions électriques (CXV0, CXV1) aux détecteurs individuels (ED0, ED1).

2. Procédé de fabrication d'un détecteur d'image lumineuse selon la revendication 1, caractérisé en ce que la première phase de dépôt de la première couche de matériau conducteur (2) est immédiatement suivie d'une phase auxiliaire de découpe dans ladite première couche de matériau conducteur (2) de colonnes conductrices (20, 21), la septième phase de gravure étant supprimée, la huitième phase consistant alors en une gravure dans les cinq couches de semi-conducteur de détecteurs individuels (ED0, ED1) situés chacun sur une colonne conductrice (20, 21).

3. Procédé de fabrication d'un détecteur linéaire d'image lumineuse comprenant plusieurs détecteurs individuels, chaque détecteur individuel étant constitué par une photodiode et une diode bloquante connectées en série, le procédé comportant les phases successives suivantes :

a) une première phase de dépôt sur une face (10) d'un substrat (1) d'une première couche d'un matériau conducteur (2) ;

b) une deuxième phase de dépôt d'une première couche (3) de semi-conducteur amorphe dopé d'un premier type de conductivité (p ou n) ;

c) une troisième phase de dépôt d'une deuxième couche (4) de semi-conducteur amorphe non dopé ;

d) une quatrième phase de dépôt d'une troisième couche (5) de semi-conducteur amorphe dopé d'un deuxième type de conductivité (n ou p) opposé au premier type de conductivité ;

e) une cinquième phase de dépôt d'une quatrième couche (6) de semi-conducteur amorphe non dopé ;

f) une sixième phase de gravure de colonnes dans les quatre couches (3 à 6) de semi-conducteur déposées précédemment, ainsi que dans la première couche de matériau conducteur (2) ;

g) une septième phase de gravure dans les quatre couches de semi-conducteur des colonnes précédentes, des détecteurs individuels (ED0, ED1) ;

h) une huitième phase d'isolation des flancs des détecteurs individuels (ED0, ED1), ainsi que des colonnes de la première couche de matériau conducteur (2) ;

i) une neuvième phase de dépôt d'une deuxième couche d'un matériau conducteur (9) fournissant un contact Schottky ;·

j) et une dixième phase de gravure dans la deuxième couche de matériau conducteur (9) des connexions électriques (CXV0, CXV1) aux détecteurs individuels (ED0, ED1).

4. Procédé de fabrication d'un détecteur d'image lumineuse selon l'une des revendications 1 ou 3, caractérisé en ce que la phase d'isolation des flancs se fait par dépôt d'une couche (8) d'un matériau isolant sur l'ensemble de la structure puis enlèvement de l'isolant à la face supérieur des détecteurs individuels (ED0, ED1).

5. Procédé de fabrication d'un détecteur d'image lumineuse selon la revendication 4, caractérisé en ce que la première couche (2) de matériau conducteur est opaque et que la phase d'isolation des flancs se fait par dépôt d'une couche d'une résine négative sur l'ensemble des détecteurs individuels (ED0, ED1), suivie d'une irradiation à l'aide d'une source lumineuse à travers le substrat (1) puis d'une opération de développement.

6. Procédé de fabrication d'un détecteur d'images lumineuses selon la revendication 4, caractérisé en ce que l'enlèvement de l'isolant (8) se fait également en des emplacements (EL0, EL1) situés sur les colonnes conductrices (20, 21).

7. Détecteur linéaire d'image lumineuse comprenant plusieurs détecteurs individuels, chaque détecteur individuel étant constitué par une photodiode et une diode bloquante connectées en série, ce détecteur comportant :
   a) - plusieurs conducteurs de colonne (20, 21) disposés sur un substrat (1) ;
   b) - plusieurs détecteurs individuels (ED0, ED1), chacun disposé sur un conducteur de colonne (20, 21) et constitué à partir de ce conducteur de colonne des couches suivantes :
      - d'une première couche (3) d'un matériau semi-conducteur amorphe dopé d'un premier type de conductivité (p ou n) ;
      - d'une deuxième couche (4) d'un matériau semi-conducteur amorphe non dopé ;
      - d'une troisième couche (5) d'un matériau semi-conducteur amorphe dopé d'un deuxième type de conductivité (n ou p) opposé au premier type de conductivité ;
      - d'une quatrième couche (6) de matériau semi-conducteur amorphe non dopé ; et, alternativement,
      - d'une cinquième couche (7) de matériau semi-conducteur amorphe dopé du premier type de conductivité (p ou n)
   c) - une couche d'isolant (8) recouvrant les flancs des détecteurs individuels ainsi que les conducteurs de colonne (20, 21) ;
   d) - des connexions électriques connectées aux faces supérieures des détecteurs individuels (ED0, ED1) et déposées sur la couche d'isolant (8), ces connexions formant des contacts Schottky ou des contacts ohmiques lorsque la cinquième couche (7) de matériau semi-conducteur amorphe dopé du premier type de conductivité est présente.

8. Détecteur linéaire d'image lumineuse à commande matricielle selon la revendication 7, caractérisé en ce que les conducteurs de colonne (20, 21) déposés sur le substrat (1) sont recouverts ainsi que les détecteurs individuels par une couche d'un matériau isolant (8) comportant des fenêtres d'accès (F0, F1, EL0, EL1) aux parties supérieures des détecteurs individuels (ED0, ED1) ainsi qu'aux conducteurs (20, 21), un premier ruban de connexion (CXV0) interconnectant les fenêtres d'accès (F0, F1) des détecteurs individuels (ED0, ED1) d'un même ensemble et permettant de les connecter à des organes extérieurs, un deuxième ruban de connexion (CXH0, CXH1) interconnectant les fenêtres d'accès des conducteurs (20, 21) de même rang des différents ensembles et connectant à des organes extérieurs.

## Claims

1. A method for the manufacture of a linear light image detector including a plurality of individual detectors, each individual detector being constituted by a photodiode and a blocking diode connected in series, said method comprising the following successive phases:
   (a) a first phase for the deposition on one surface (10) of a substrate (1) of a first layer of a conductive material (2);
   (b) a second phase for the deposition of a first layer (3) of amorphous semiconductor doped to have a first type (p or n) of conductivity;
   (c) a third phase for the deposition of a secnd layer (4) of undoped amorphous semiconductor;
   (d) a fourth phase for the disposition of a third layer (5) of amorphous semiconductor doped to have a second type (n or·p) of conductivity opposite to the first type;
   (e) a fifth phase for the deposition of a fourth layer (6) of undoped amorphous semiconductor;
   (f) a sixth phase for the deposition of a fifth layer (7) of undoped amorphous semiconductor of the first type (p or n) of conductivity;
   (g) a seventh phase for producing by engraving of columns in the five layers (3 through 7) of previously deposited semiconductor and of the first layer of conductive material (2);
   (h) an eighth phase of producing by engraving, in the five layers of semiconductor of the preceding columns, individual detectors (ED0 and ED1);

(i) a ninth phase of insulation of the sides of the individual detectors (ED0 and ED1) as well as of the columns of the first layer of conductive material (2);

(j) a tenth phase for the deposition of a second layer of a semiconductor material (9) providing an ohmic contact;

(k) and an eleventh phase for producing by engraving, in the second layer of this material (9), electrical connections (CXV0 and CXV1) with the individual detectors (ED0 and ED1).

2. The method for the manufacture of a light image detector as claimed in claim 1, characterized in that the first phase for the deposition of the first layer of conductive material (2) is directly followed by an auxiliary phase for cutting, in the said first layer of conductive material (2), of conductive columns (20 and 21), the seventh phase of engraving being omitted, the eighth phase the constituting of producing by engraving, in the five layers of semiconductor, individual detectors (ED0 and ED1) each positioned on one conductive column (20 and 21).

3. A method for the manufacture of a linear light image detector, each individual detector being constituted by a photodiode and a blocking diode connected in series, said method comprising the following successive phases;

(a) a first phase for the deposition on one surface (10) of a substrate (1) of a first layer of a conductive material (2);

(b) a second phase for the deposition of a first layer (3) of amorphous semiconductor doped to have first type (p or n) of conductivity;

(c) a third phase for the disposition of a second layer (4) of amorphous undoped semiconductor,

(d) a fourth phase for the deposition of a third layer (5) of undoped amorphous semiconductor doped to have a second type (n or p) of conductivity opposite to the first type of conductivity;

(e) a fifth phase for the deposition of a fourth layer (6) of undoped amorphous semiconductor;

(f) a sixth phase for the production by engraving of columns in the fourth layers (3 through 6) of previously deposited semiconductor, as well as in the first layer of conductive material (2);

(g) a seventh phase for the producing by engraving of columns, in the four layers of semiconductor of the preceding columns, of individual detectors (ED0 and ED1);

(h) an eighth phase of insulating the sides of the individual detectors (ED0 and ED1) as well as of the columns of the first layer of conductive material (2);

(i) a ninth phase of deposition of a second layer of a conductive material (9) leading to a Schottky contact, and;

(j) a tenth phase of producing by engraving, in the second layer of conductive material (9), electrical connections (CXV0 and CXV1) with the individual detectors (ED0 and ED1).

4. The method for the manufacture of a light image detector as claimed in claim 1 or in claim 3, characterized in that the phase of insulation of the sides is performed by the deposition of a layer (8) of an insulating material on the totality of the structure and then the removal of the insulator from the upper surface of the individual detectors (ED0 and ED1).

5. A method for the manufacture of a light image detector as claimed in claim 4, characterized in that the first layer (2) of conductive material is opaque and in that the phase of insulating the sides is performed by the deposition of a layer of negative resin on the totality of the individual detectors (ED0 and ED1), followed by irradiation with the aid of a light source through the substrate (1) and then a development operation.

6. The method for the manufacture of a light image detector as claimed in claim 4, characterized in that the removal of the insulator (8) is also performed in sites (EL0 and EL1) positioned on conductive columns (20 and 21).

7. A linear light image detector, comprising a plurality of individual detectors, each individual detector being constituted by a photodiode and a blocking diode connected in series, said detector comprising:

(a) a plurality of column conductors (20 and 21) positioned on a substrate (1);

(b) a plurality of individual detectors (ED0 and ED1), each being positioned on a column conductor ( and 21) and each constituted, starting with the column conductor, of the following layers:

- a first layer (3) of an amorphous semiconductor material doped to have a first type (p or n) of conductivity;

- a second layer (4) of an undoped amorphous semiconductor material;

- a third layer (5) of a doped amorphous semiconductor material with a type of conductivity (n or p) opposite to the first type of conductivity;

- a fourth layer (6) of undoped amorphous semiconductor material; and, alternatively, of a fifth layer (7) of amorphous semiconductor material doped to have the first type (p or n) of conductivity;

(c) a layer of insulator (8) covering the sides of the individual detectors as well as the column conductors (20 and 21); and

(d) electrical connections connected with the upper sides of the individual detectors (ED0 and ED1) and positioned on the insulating layer (8), said connections constituting Schottky contacts or ohmic contacts if the fifth layer (7) of the amorphous semiconductor material doped to have the first type of conductivity is present.

8. A matrix control linear light image detector as claimed in claim 7, characterized in that the column conductors (20 and 21) positioned on the substrate (1), and also the individual detectors, are covered by a layer of insulating material (8) comprising access windows (F0, F1, EL0 and EL1) to the upper parts of the individual conductors (ED0 and ED1) as well as to the conductors (20 and 21), a first connection band (CXV0) interconnecting the access windows (F0 and F1) of the individual detectors (ED0 and ED1) of a given set and permitting connection of the same with outside instrumentalities, a second connection band (CXH0 and CXH1) interconnecting the access windows of the conductors (20 and 21) of a given rank of the different sets and connected with outside instrumentalities.

**Patentansprüche**

1. Verfahren zur Herstellung eines linearen Leuchtbilddetektors mit einer Mehrzahl von Einzeldetektoren, wobei jeder Einzeldetektor von einer Photodiode und einer Trenndiode, die in Reihe geschaltet sind, gebildet wird, wobei das Verfahren die folgenden aufeinanderfolgenden Phasen enthält:

a) eine erste Phase des Abscheidens einer ersten Schicht eines leitenden Materials (2) auf einer Seite (10) eines Substrats (1);

b) eine zweite Phase des Abscheidens einer ersten Schicht (3) eines amorphen Halbleiters, der mit einem ersten Leitungstyp (p oder n) dotiert ist;

c) eine dritte Phase des Abscheidens einer zweiten Schicht (4) eines nicht dotierten amorphen Halbleiters;

d) eine vierte Phase des Abscheidens einer dritten Schicht (5) eines amorphen Halbleiters, der mit einem zweiten Leitungstyp (n oder p), der dem ersten Leitungstyp entgegengesetzt ist, dotiert ist;

e) eine fünfte Phase des Abscheidens einer vierten Schicht (6) eines nicht dotierten amorphen Halbleiters;

f) eine sechste Phase des Abscheidens einer fünften Schicht (7) eines amorphen Halbleiters, der mit dem ersten Leitungstyp (p oder n) dotiert ist;

g) eine siebte Phase des Ätzens von Spalten in den fünf vorher abgeschiedenen Halbleiterschichten (3 bis 7) sowie in der ersten Schicht des leitenden Materials (2);

h) eine achte Phase des Ätzens von Einzeldetektoren (ED0, ED1) in den fünf Halbleiterschichten der vorigen Spalten;

i) eine neunte Phase der Isolation der Seitenflächen der Einzeldetektoren (ED0, ED1) sowie der Spalten der ersten Schicht des leitenden Materials (2);

j) eine zehnte Phase des Abscheidens einer zweiten Schicht eines einen Ohmschen Kontakt liefernden leitenden Materials (9);

k) und eine elfte Phase des Ätzens von elektrischen Verbindungen (CXV0, CXV1) an die Einzeldetektoren (ED0, ED1) in der zweiten Schicht des leitenden Materials (9).

2. Verfahren zur Herstellung eines Leuchtbilddetektors gemäß Anspruch 1, dadurch gekennzeichnet, daß der ersten Phase des Abscheidens der ersten Schicht des leitenden Materials (2) unmittelbar eine Hilfsphase des Abtrennens von Leiterspalten (20, 21) in der ersten Schicht des leitenden Materials folgt, wobei die siebte Phase des Ätzens weggelassen wird und die achte Phase folglich eine Ätzung von Einzeldetektoren (ED0, ED1), die jeweils auf einer Leiterspalte (20, 21) angeordnet sind, in den fünf Halbleiterschichten umfaßt.

3. Verfahren zur Herstellung eines linearen Leuchtbilddetektors mit einer Mehrzahl von Einzeldetektoren, wobei jeder Einzeldetektor von einer Photodiode und einer Trenndiode, die in Reihe geschaltet sind, gebildet wird, wobei das Verfahren die folgenden aufeinanderfolgenden Phasen enthält:

a) eine erste Phase des Abscheidens einer ersten Schicht eines leitenden Materials (2) auf einer Seite (10) eines Substrats (1);

b) eine zweite Phase des Abscheidens einer ersten Schicht (3) eines amorphen Halbleiters, der mit einem ersten Leitungstyp (p oder n) dotiert ist;

c) eine dritte Phase des Abscheidens einer zweiten Schicht (4) eines nicht dotierten amorphen Halbleiters;

d) eine vierte Phase des Abscheidens einer dritten Schicht (5) eines amorphen Halbleiters, der mit einem zweiten Leitungstyp (n oder p), der dem ersten Leitungstyp entgegengesetzt ist, dotiert ist;

e) eine fünfte Phase des Abscheidens einer vierten Schicht (6) eines nicht dotierten amorphen Halbleiters;

f) eine sechste Phase des Ätzens von Spalten in den vier Schichten (3 bis 6) des vorher abgeschiedenen Halbleiters sowie in der ersten Schicht des leitenden Materials (2);

g) eine siebte Phase des Ätzens von Einzeldetektoren (ED0, ED1) in den vier Halbleiterschichten der vorigen Spalten;

h) eine achte Phase der Isolation der Seiten der Einzeldetektoren (ED0, ED1) sowie der Spalten der ersten Schicht des leitenden Materials (2);

i) eine neunte Phase des Abscheidens einer zweiten Schicht eines leitenden Materials (9), das einen Schottky-Kontakt liefert;

j) und eine zehnte Phase des Ätzens von elektrischen Verbindungen (CXV0, CXV1) an die Einzeldetektoren (ED0, ED1) in der zweiten Schicht des leitenden Materials (9).

4. Verfahren zur Herstellung eines Leuchtbilddetektors gemäß einem der Ansprüche 1 oder 3, dadurch gekennzeichnet, daß die Phase der Isolation der Seitenflächen durch das Abscheiden einer Schicht (8) eines isolierenden Materials auf der gesamten Struktur und dann durch ein Abtragen des Isolators bis zur Oberseite der Einzeldetektoren (ED0, ED1) ausgeführt wird.

5. Verfahren zur Herstellung eines Leuchtbildddetektors gemäß Anspruch 4, dadurch gekennzeichnet, daß die erste Schicht (2) des leitenden Materials lichtundurchlässig ist und daß die Phase der Isolation der Seitenflächen durch das Abscheiden einer Negativharz-Schicht auf der Gesamtheit der Einzeldetektoren (ED0, ED1), gefolgt von einer Bestrahlung durch das Substrat (1) mit Hilfe einer Lichtquelle und von einer Entwicklungsoperation, ausgeführt wird.

6. Verfahren zur Herstellung eines Leuchtbilddetektors gemäß Anspruch 4, dadurch gekennzeichnet, daß das Abtragen des Isolators (8) ebenso an Stellen (EL0, EL1), die sich auf den Leitersäulen (20, 21) befinden, ausgeführt wird.

7. Linearer Leuchtbilddetektor mit einer Mehrzahl von Einzeldetektoren, wobei jeder Einzeldetektor von einer Photodiode und einer Trenndiode, die in Reihe geschaltet sind, gebildet wird, wobei dieser Detektor umfaßt:

a) - eine Mehrzahl von auf einem Substrat (1) angeordneten Säulenleitern (20, 21);

b) - eine Mehrzahl von Einzeldetektoren (ED0, ED1), die jeweils auf einem Spaltenleiter (20, 21) angeordnet sind und auf diesen Spaltenleitern durch die folgenden Schichten gebildet werden:

- eine erste Schicht (3) eines amorphen Halbleitermaterials, das mit einem ersten Leitungstyp (p oder n) dotiert ist;

- eine zweite Schicht (4) eines nicht dotierten amorphen Halbleiters;

- eine dritte Schicht (5) eines amorphen Halbleitermaterials, das mit einem zweiten Leitungstyp (n oder p), der dem ersten Leitungstyp entgegengesetzt ist, dotiert ist;

- eine vierte Schicht (6) eines nicht dotierten amorphen Halbleitermaterials; und alternativ

- eine fünfte Schicht (7) eines amorphen Halbleitermaterials, das mit dem ersten Leitungstyp (p oder n) dotiert ist;

c) - eine Isolierschicht (8), die die Seitenflächen der Einzeldetektoren sowie die Spaltenleiter (20, 21) bedeckt;

d) - elektrische Verbindungen, die mit den Oberseiten der Einzeldetektoren (ED0, ED1) verbunden und auf der Isolierschicht (8) angeordnet sind, wobei diese Verbindungen Schottky-Kontakte oder Ohmsche Kontakte bilden, wenn die fünfte Schicht (7) des amorphen Halbleitermaterials, das mit dem ersten Leitungstyp dotiert ist, vorhanden ist.

8. Linearer Leuchtbilddetektor mit Materixsteuerung gemäß Anspruch 7, dadurch gekennzeichnet, daß die auf dem Substrat (1) abgeschiedenen Spaltenleiter (20, 21) sowie die Einzeldetektoren von einer Schicht eines isolierenden Materials (8), das an den oberen Bereichen der Einzeldetektoren (ED0, ED1) sowie an den Leitern (20, 21) Zugriffsfenster (F0, F1, EL0, EL1) enthält, überzogen sind, wobei ein erstes Verbindungsband (CXV0) die Zugriffsfenster (F0, F1) der Einzeldetektoren (ED0, ED1) derselben Gruppe verbindet und deren Verbindung mit externen Elementen gestattet, wobei ein zweites Verbindungsband (CXH0, CXH1) die Zugriffsfenster der Leiter derselben Reihe unterschiedlicher Gruppen miteinander und mit externen Elementen verbindet.

# Fig.1

25μm  100μm  25μm

21  10  20  2

ITO  ITO  ITO  1

SUBSTRAT

# Fig.2

SiP+  7
Si i  6
Si n+  5
Si i
SiP+

ITO  ITO  20 3 4  ITO  1

SUBSTRAT

# Fig.3

ED1  EDO  5 6 7

SiP+
Si i  4
Si n+
Si i  3
SiP+

21  20  1

SUBSTRAT

# Fig.4

5 6 7  8

ISOLANT
SiP+
Si i
Si n+
Si i
SiP+

21  20 3 4  1

SUBSTRAT

Fig.5

Fig.6

Fig.7

12

Fig.8

EP 0 214 033 B1

CXH0

CXH1

ED0

ED1

Fig.9

CXV0

CXV1

EP 0 214 033 B1